# EUROPÄISCHE PATENTSCHRIFT

(11) **EP 2 823 180 B1**
(45) Veröffentlichungstag und Bekanntmachung des Hinweises auf die Patenterteilung: **11.04.2018**
(21) Anmeldenummer: 13704060.6
(22) Anmeldetag: 07.02.2013
(51) Int. Cl.: F02P 19/02, H03K 17/08, H02H 11/00

(54) **GLÜHZEITSTEUERGERÄT**
GLOW TIME CONTROL DEVICE
APPAREIL DE COMMANDE DU TEMPS DE PRÉCHAUFFAGE

(30) Priorität: 03.03.2012 DE 102012004387
(43) Veröffentlichungstag der Anmeldung: 14.01.2015
(73) Patentinhaber: Volkswagen Aktiengesellschaft, 38440 Wolfsburg (DE)
(72) Erfinder: HABERMANN, Viktoria, 38436 Wolfsburg (DE); SCHILLINGER, Wolf-Rüdiger, 38436 Wolfsburg (DE)
(86) Internationale Anmeldenummer: PCT/EP2013/052367
(87) Internationale Veröffentlichungsnummer: WO 2013/131702

(56) Entgegenhaltungen:
- DE-A1-102008 001 114
- JP-A- S55 134 761
- JP-A- 2008 063 967

## Beschreibung

Die vorliegende Erfindung betrifft ein Glühzeitsteuergerät zum Ansteuern von Glühkerzen in einem Motor eines Fahrzeugs. Die vorliegende Erfindung betrifft insbesondere Schutzschaltungen in dem Glühzeitsteuergerät, um eine Beschädigung des Glühzeitsteuergeräts und der daran angeschlossenen Glühkerzen zu vermeiden.

Verbrennungsmotoren von Kraftfahrzeugen, wie z.B. Personenkraftwagen oder Lastkraftwagen, insbesondere Dieselmotoren, können Glühkerzen verwenden, um eine Verbrennung in dem Verbrennungsmotor zu unterstützen. Derartige Glühkerzen werden auch als Glühstifte bezeichnet. Die Glühkerzen werden von einem Glühzeitsteuergerät mittels elektrischer Energie von einem Bordnetz des Fahrzeugs angesteuert. Glühstifte werden normalerweise mit einer vorgegebenen Nennspannung von beispielsweise 5,5 V betrieben. Bei einem fehlerhaften Anschluss des Glühzeitsteuergeräts bei der Montage oder Wartung des Fahrzeugs können Spannungen an Ein- und Ausgängen des Glühzeitsteuergeräts angelegt werden, welche das Glühzeitsteuergerät beschädigen oder zerstören können. Ein zerstörtes oder beschädigtes Glühzeitsteuergerät kann wiederum einen daran angeschlossenen Glühstift beschädigen.

In diesem Zusammenhang ist aus der DE 100 13 939 A1 ein elektrischer Schaltkreis mit Verpolungsschutz bekannt. In der positiven Versorgungsleitung des Schaltkreises ist ein Verpolungsschutz vorgesehen und der Verpolungsschutz weist einen N-Kanal MOSFET-Transistor mit parallel geschalteter Zener-Diode und einem Kleinsignal-MOSFET-Transistor mit parallel geschalteter Zener-Diode auf. Die Drain-Anschlüsse der beiden Transistoren sind zur Speisung durch die positive Versorgungsleitung vorgesehen und der Gate-Anschluss des N-Kanal MOSFET-Transistors ist zur Versorgung durch eine Leistungsbrückenschaltung vorgesehen und mit dem Source-Anschluss des Kleinsignal-MOSFET-Transistors verbunden.

Die DE 10 2008 001 114 A1 betrifft eine Steuerschaltung für Glühstiftkerzen zum Schutz vor Verpolung. Eine Steuereinheit umfasst einen ersten Feldeffekttransistor, welcher mit der Glühkerze in einem gemeinsamen Strompfad verschaltet ist. Ferner ist ein zweiter Feldeffekttransistor vorgesehen, der gegenläufig mit dem ersten Transistor verbunden ist, so dass der Stromfluss in dem Strompfad in beiden Richtungen blockiert ist. Eine Schalteinheit ist zum Aktivieren des zweiten Transistors ausgebildet, so dass der Stromfluss in Richtung eines Strompfads freigeben werden kann, die der vorgeschriebenen Polung der Glühkerze entspricht.

Die DE 100 48 184 A1 betrifft eine Gegenspannungsschutzschaltung zum Schutz eines über eine Gleichspannungsquelle versorgten Steuergeräts gegen eine im Fall einer Umpolung auftretende Gegenspannung. Die Gegenspannungsschutzschaltung umfasst einen zwischen die Gleichspannungsquelle und das Steuergerät geschalteten MOSFET, dessen Source-Anschluss mit der positiven Klemme der Gleichspannungsquelle verbunden ist, und dessen Gate-Anschluss über einen durch das Steuergerät ansteuerbaren Treiber so beaufschlagbar ist, dass der MOSFET eingeschaltet wird. Die Gate-Source-Strecke des MOSFET kann durch zwei gegensinnig in Reihe geschaltete Z-Dioden, die über ihre Anoden miteinander verbunden sind, gegen Überspannung geschützt werden.

Die DE 198 177 90 A1 betrifft eine Verpolschutzschaltung, bei welcher parallel zu einer Verpolschutzdiode ein Halbleiterschalter geschaltet ist, welcher im Verpolungsfall ausgeschaltet und im Normalbetrieb eingeschaltet ist.

Die DE 198 40300 A1 betrifft eine Verpolschutzschaltung für eine elektronische, über eine Ansteuerschaltung ansteuerbare Leistungsendstufe. Bei der Verpolschutzschaltung wird bei falscher Polung der Versorgungsspannung mittels Power-FETs in mindestens einem Versorgungsanschluss eine Durchschaltung der falsch angelegten Versorgungsspannung zur Ansteuerschaltung und zur Leistungsendstufe unterbrochen.

Die DE 41 344 95 A1 betrifft eine Steuereinrichtung für elektrische Motoren in Fahrzeugen, welche die Anforderungen bezüglich Kurzschlussfestigkeit, Verpolschutz, Load-Dump-Schutz, Verriegelungen gegen Fehlfunktionen usw. erfüllt. Der Verpolschutz wird durch einen Transistor realisiert. Soll der Motor Strom aufnehmen, so wird über zwei Dioden sowie einen Widerstand der Transistor eingeschaltet. Zu diesem Zeitpunkt würde der Transistor invers betrieben. Dadurch wird die parasitäre Diode (Source-Drain) des Transistors sehr stark entlastet, da der Strom über die Drain-Source-Strecke fließt. Es tritt nur eine deutlich verminderte Verlustleistung auf.

Das Dokument JP 2008 063967 A offenbart ein Glühzeitsteuergerät zum Ansteuern von Glühstiften in einem Fahrzeug. Es umfasst eine Steuereinheit mit einem Steuerausgang zum Ausgeben eines Steuersignals und einem Versorgungsspannungseingang und mindestens zwei Leistungstransistoren, welchen jeweils ein entsprechender Glühstiftsteuerausgang zugeordnet ist und deren Steuereingänge mit einem Steuerausgang der Steuereinheit gekoppelt sind. Des Weiteren weist das Glühzeitsteuergerät einen Schutzschaltkreis mit einem Schutzschaltkreisausgang auf, welcher mit den Steuereingängen der mindestens zwei Leistungstransistoren gekoppelt ist. Der Schutzschaltkreis hat der Schutzschaltkreis einen Eingang, welcher mit dem Versorgungsspannungseingang der Steuereinheit gekoppelt ist, wobei der Schutzschaltkreis eingerichtet ist, an dem Schutzschaltkreisausgang ein vorgegebenes Potential einzustellen, wenn die Versorgungsspannung der Steuereinheit unterhalb eines vorgegebenen Werts ist.

Neben einer Verpolung und einem unbeabsichtigten Anschluss von +12 V oder Masse an einen Anschluss des Glühzeitsteuergeräts können auch elektrostatische Entladungen an den Anschlüssen des Glühzeitsteuergeräts eine Zerstörung des Glühzeitsteuergeräts bewirken. Weiterhin können insbesondere bei einem Glühzeitsteuergerät, welches zur Ansteuerung von mehreren Glühstiften bei einem Mehrzylindermotor geeignet ist, Wechselwirkungen zwischen den Steuerausgängen für die Glühstifte auftreten. Dies kann insbesondere dann auftreten, wenn mehrere Leistungsschalter, beispielsweise FETs, in dem Glühzeitsteuergerät von einem gemeinsamen Steuerausgang einer Steuereinheit des Glühzeitsteuergeräts angesteuert werden.

Aufgabe der vorliegenden Erfindung ist es daher, Schutzschaltungen in dem Glühzeitsteuergerät bereitzustellen, welche eine Zerstörung des Glühzeitsteuergeräts und der daran angeschlossenen Glühstifte bei einer unsachgemäßen Beschaltung des Glühzeitsteuergeräts verhindern.

Diese Aufgabe wird gemäß der vorliegenden Erfindung durch ein Glühzeitsteuergerät nach Anspruch 1 gelöst. Die abhängigen Ansprüche definieren bevorzugte und vorteilhafte Ausführungsformen der Erfindung.

Gemäß der vorliegenden Erfindung wird ein Glühzeitsteuergerät zum Ansteuern von Glühstiften in einem Fahrzeug bereitgestellt. Das Glühzeitsteuergerät umfasst eine Steuereinheit, mindestens zwei Leistungstransistoren und einen Schutzschaltkreis. Die Steuereinheit weist einen Steuerausgang zum Ausgeben eines Steuersignals auf. Weiterhin weist die Steuereinheit einen Versorgungsspannungseingang und einen Versorgungsspannungsausgang auf und ist ausgestaltet, in Abhängigkeit von einer Spannung an dem Versorgungsspannungseingang eine Ausgangsspannung an dem Versorgungsspannungsausgang bereitzustellen. Jedem der mindestens zwei Leistungstransistoren ist jeweils ein entsprechender Glühstiftsteuerausgang des Glühzeitsteuergeräts zugeordnet und die Steuereingänge der mindestens zwei Leistungstransistoren sind mit dem Steuerausgang der Steuereinheit gemeinsam gekoppelt. An die Glühstiftsteuerausgänge können Glühstifte angeschlossen und somit angesteuert werden. Der Schutzschaltkreis umfasst einen Schutzschaltkreisausgang, welcher mit den Steuereingängen der mindestens zwei Leistungstransistoren gekoppelt ist, und einen Eingang, welcher mit dem Versorgungsspannungsausgang der Steuereinheit gekoppelt ist. Der Schutzschaltkreis ist ausgestaltet, an dem Schutzschaltkreisausgang ein vorgegebenes Potenzial einzustellen, wenn die Ausgangsspannung der Steuereinheit unterhalb eines vorgegebenen Wertes ist. Dadurch kann sichergestellt werden, dass die Leistungstransistoren gesperrt werden, wenn kein zuverlässiges Signal von der Steuereinheit zur Verfügung gestellt wird, was beispielsweise auftreten kann, wenn die Steuereinheit nicht zuverlässig mit einer Versorgungsspannung oder Masse gekoppelt ist. In diesem Fall wird an dem Versorgungsspannungsausgang der Steuereinheit nicht die gewünschte Versorgungsspannung bereitgestellt und der Schutzschaltkreis gibt an seinem Schutzschaltkreisausgang ein Potenzial aus, welches die Leistungstransistoren sperrt. Beispielsweise kann das vorgegebene Potenzial an dem Schutzschaltkreisausgang zum Sperren der Leistungstransistoren ein Massepotenzial sein. Weiterhin kann durch den Schutzschaltkreis sichergestellt werden, dass sich die Leistungstransistoren nicht gegenseitig beeinflussen, wenn kein zuverlässiges Steuersignal von der Steuereinheit an den Steuereingängen der Leistungstransistoren anliegt. Wenn beispielsweise an den Glühstiftsteuerausgang eines Leistungstransistors ein hohes positives Potenzial angelegt wird, beispielsweise +12 V, könnte der Steuereingang des Leistungstransistors ebenfalls angehoben werden, wodurch aufgrund der gemeinsamen Verbindung der Steuereingänge der Leistungstransistoren mit dem Steuerausgang der Steuereinheit auch der Steuereingang des anderen Leistungstransistors angehoben werden, wodurch dieser wiederum fälschlicherweise durchschalten würde. Der Schutzschaltkreis verhindert dies, indem ein Potenzial an die Steuereingänge der Leistungstransistoren angelegt wird, welches die Leistungstransistoren sperrt, wenn die Steuereinheit an ihrem Steuerausgang keine zuverlässige Ansteuerung für die Leistungstransistoren bereitstellt.

Es werden Ausführungsformen von erfindungsgemäßen Glühzeitsteuergeräten zum Ansteuern von Glühstiften in einem Fahrzeug bereitgestellt, welche eine Steuereinheit, mindestens zwei Leistungstransistoren und mindestens zwei Transistoren umfasst. Die Steuereinheit weist einen Steuerausgang zum Ausgeben eines Steuersignals auf. Den Leistungstransistoren ist jeweils ein entsprechender Glühstiftsteuerausgang zugeordnet und die Steuereingänge der Leistungstransistoren sind gemeinsam mit dem Steuerausgang der Steuereinheit gekoppelt. Die Transistoren der mindestens zwei Transistoren sind jeweils einem der mindestens zwei Leistungstransistoren zugeordnet, d.h. jedem Leistungstransistor ist zusätzlich ein Transistor zugeordnet. Eine Schaltstrecke des Transistors, welcher dem Leistungstransistor zugeordnet ist, ist zwischen den Steuereingang und einen Ausgang des Leistungstransistors geschaltet. Zusätzlich ist zwischen den Transistor und den Steuereingang des Leistungstransistors eine Diode geschaltet. Die Transistoren können die Leistungstransistoren zuverlässig ausschalten, wenn das Massepotenzial des Glühzeitsteuergeräts beispielsweise durch eine Unterbrechung einer Masseverbindung ansteigt. Die Dioden verhindern, dass ein hohes Potenzial an einem Glühstiftsteuerausgang eines Leistungstransistors das Potenzial des Steuereingangs eines anderen Leistungstransistors über die Kopplung der Steuereingänge der Leistungstransistoren anhebt. Dadurch kann ein unbeabsichtigtes Durchschalten der Leistungstransistoren auch bei einem Masseverlust oder Masseversatz zuverlässig verhindert werden.

Gemäß einer Ausführungsform umfasst der Leistungstransistor einen Feldeffekttransistor, beispielsweise einen MOSFET- oder Leistungs-FET, mit einem Gate-Anschluss als dem Steuereingang sowie einem Source-Anschluss und einem Drain-Anschluss. Ein Emitter des Transistors, welcher dem Leistungstransistor zugeordnet ist, ist mit dem Source-Anschluss gekoppelt. Ein Kollektoranschluss des Transistors ist über die Diode mit dem Gate-Anschluss gekoppelt und eine Basis des Transistors ist über einen Kondensator mit dem Source-Anschluss gekoppelt und über eine weitere Diode mit einem Masseanschluss des Glühzeitsteuergeräts gekoppelt. Durch die weitere Diode werden die Basisströme der Transistoren entkoppelt und eine Stromflussrichtung der Basisströme vorgegeben. Bei einem Masseversatz bzw. Masseverlust des Glühzeitsteuergeräts werden die Leistungstransistoren von den Transistoren ausgeschaltet, bevor das Massepotenzial über eine Schwellenspannung, welche durch die Diodenspannung der weiteren Dioden eingestellt wird, in Bezug auf das Glühstiftmassepotenzial ansteigt. Der Kondensator verzögert das Ausschalten der Leistungstransistoren um beispielsweise 50 bis 100 µs, wodurch eine Entprellung erreicht wird.

Gemäß einer weiteren Ausführungsform umfasst die Diode eine Schottky-Diode. Schottky-Dioden weisen eine verhältnismäßig geringe Vorwärtsspannung auf, wodurch die Leistungstransistoren zuverlässig ausgeschaltet werden können, indem die Spannung am Gate des Leistungstransistors unterhalb von beispielsweise einer FET-Schwellenspannung von typischerweise 2 V gehalten werden kann.

Gemäß einem weiteren Aspekt der vorliegenden Erfindung wird eine Ausführungsform eines erfindungsgemäßen Glühzeitsteuergeräts zum Ansteuern von Glühstiften in einem Fahrzeug bereitgestellt, welche eine Steuereinheit, mindestens zwei Leistungstransistoren und mindestens zwei Zener-Dioden-Paare umfasst. Die Steuereinheit weist einen Steuerausgang zum Ausgeben eines Steuersignals auf. Den Leistungstransistoren ist jeweils ein entsprechender Glühstiftsteuerausgang zugeordnet und Steuereingänge der Leistungstransistoren sind mit dem Steuerausgang der Steuereinheit gekoppelt. Jedes Zener-Dioden-Paar ist jeweils einem der Leistungstransistoren zugeordnet und zwischen den Steuereingang und einem Ausgang des Leistungstransistors geschaltet. Ein Zener-Dioden-Paar umfasst eine Reihenschaltung von zwei Zener-Dioden, welche in entgegengesetzte Richtung geschaltet sind. Die Zener-Dioden können beispielsweise eine Zener-Spannung von 18 V aufweisen. Bei einem Kurzschluss des Ausgangs eines Leistungstransistors nach Masse kann dadurch eine Überspannung an dem Steueranschluss des Leistungstransistors und an dem Steueranschluss eines weiteren Leistungstransistors vermieden werden.

Gemäß der vorliegenden Erfindung wird weiterhin eine Ausführungsform eines erfindungsgemäßen Glühzeitsteuergeräts bereitgestellt, welche eine Leiterplatte, einen Masseanschluss und mindestens einen elektrischen Anschluss auf der Leiterplatte umfasst. Der Masseanschluss ist mit einer ersten Leiterbahn der Leiterplatte gekoppelt. Der elektrische Anschluss ist mit einer zweiten Leiterbahn der Leiterplatte gekoppelt und zum Verbinden der zweiten Leiterbahn mit einer zu dem Glühzeitsteuergerät externen Vorrichtung ausgestaltet. Der elektrische Anschluss kann beispielsweise einen Anschlussstift umfassen, welcher ein Steuersignal für das Glühzeitsteuergerät von einer externen Vorrichtung entgegennimmt oder ein Steuersignal zu einer externen Vorrichtung, beispielsweise einem Glühstift, ausgibt. Das Glühzeitsteuergerät umfasst weiterhin eine ESD-Funkenstrecke, welche benachbart zu dem elektrischen Anschluss zwischen der ersten Leiterbahn und der zweiten Leiterbahn ausgebildet ist. Eine ESD-Funkenstrecke umfasst beispielsweise eine Luftstrecke zwischen der ersten Leiterbahn und der zweiten Leiterbahn mit einer vorgegebenen Länge, d.h. die ESD-Funkenstrecke wird dadurch gebildet, dass die erste Leiterbahn und die zweite Leiterbahn auf einen Abstand der vorgegebenen Länge aneinander herangeführt werden, ohne sich jedoch zu berühren. Die erste Leiterbahn und die zweite Leiterbahn sind somit im Bereich der ESD-Funkenstrecke elektrisch voneinander isoliert. Durch den Abstand vorgegebener Länge von beispielsweise weniger als 1 mm, beispielsweise 0,1 mm, können im Bereich der ESD-Funkenstrecke hohe Spannungen zwischen der ersten Leiterbahn und der zweiten Leiterbahn zur Ausbildung eines Lichtbogens führen, wodurch derartig hohe Spannungen bereits an dem elektrischen Anschluss auf der Leiterplatte nach Masse abgeführt werden und somit eine Beschädigung von Komponenten des Glühzeitsteuergeräts verhindert werden kann. Die hohen Spannungen können beispielsweise durch elektrostatische Entladungen (engl.: Electrostatic Discharge, ESD) auftreten.

Gemäß einem weiteren Aspekt der vorliegenden Erfindung wird eine Ausführungsform eines erfindungsgemäßen Glühzeitsteuergeräts zum Ansteuern von Glühstiften in einem Fahrzeug bereitgestellt, welche mindestens zwei Leistungstransistoren und mindestens zwei Sicherungen umfasst. Jedem Leistungstransistor ist ein entsprechender Glühstiftsteuerausgang zugeordnet. Jede Sicherung ist jeweils einem der mindestens zwei Leistungstransistoren zugeordnet, d.h. jeder Leistungstransistor und jeder daran angeschlossen Glühstift ist einzeln abgesichert. Verglichen mit einer gemeinsamen Absicherung aller Leistungstransistoren über eine gemeinsame Sicherung können die einzelnen Sicherungen niedrigere Schwellen aufweisen, welche zum Auslösen der Sicherung überschritten werden müssen. Dadurch kann ein besserer Schutz der Leistungstransistoren und Glühstifte sichergestellt werden, insbesondere wenn nur in einem Glühstiftkreis ein Fehler und somit eine Überlastung vorliegt. Weiterhin ist ein Betrieb der übrigen Glühstiftkreise möglich, wenn ein Glühstiftkreis durch eine Fehlbeschaltung oder eine Überlast mittels der zugeordneten Sicherung abgeschaltet wurde. Dadurch kann ein zuverlässigerer Betrieb eines Motors, in welchem die Glühstifte verwendet werden, sichergestellt
werden und Schäden an dem Motor verhindert werden. Die Sicherungen können beispielsweise Schmelzsicherungen oder elektronische Sicherungen oder selbtsrückstellende Sicherungen umfassen.

Gemäß der vorliegenden Erfindung wird weiterhin ein Fahrzeug bereitgestellt, welches mindestens einen Glühstift und das zuvor beschriebene Steuergerät umfasst, welches mit dem mindestens einen Glühstift gekoppelt ist. Das Fahrzeug umfasst somit auch die Vorteile des zuvor beschriebenen Glühzeitsteuergeräts.

Obwohl die speziellen Merkmale, welche in der obigen Zusammenfassung und der nachfolgenden detaillierten Beschreibung in Verbindung mit speziellen Ausführungsformen der Erfindung beschrieben wurden, ist es klar, dass die Merkmale der zuvor beschriebenen Ausführungsformen miteinander kombiniert werden können. Insbesondere kann das Glühzeitsteuergerät mehrere oder alle der zuvor beschriebenen Merkmale umfassen, wodurch ein hoher Schutz des Glühzeitsteuergeräts und der daran angeschlossenen Glühstifte auch bei einem fehlerhaften Anschluss von elektrischen Leitungen an dem Glühzeitsteuergerät oder an den Glühstiften sichergestellt werden kann.

Die vorliegende Erfindung wird nachfolgend unter Bezugnahme auf die Zeichnung im Detail beschrieben werden.
Fig. 1 zeigt einen Schaltplan eines Glühzeitsteuergeräts gemäß einer Ausführungsform der vorliegenden Erfindung.
Fig. 2 zeigt ein Fahrzeug mit einem Glühzeitsteuergerät gemäß einer Ausführungsform der vorliegenden Erfindung.

Bei Dieselmotoren werden Glühkerzen, welche auch als Glühstifte bezeichnet werden, verwendet, um insbesondere bei einem Kaltstart des Dieselmotors den in den Brennraum eingespritzten Dieselkraftstoff zuverlässig zu entzünden. Um bei diesem Vorglühvorgang die für den Motorstart erforderliche Glühtemperatur möglichst schnell zu erreichen, werden die Glühstifte in dieser Phase kurzfristig mit einer erhöhten Spannung, der sogenannten Push-Spannung, oberhalb der Glühstiftnennspannung betrieben. Danach werden die Glühstifte mit der Nennspannung (Glühen) oder sogar unterhalb der Glühspannung (Nachglühen) betrieben. Die Spannung der Glühstifte wird über ein pulsweitenmoduliertes Signal (PWM-Signal) geregelt, welches von einem Motorsteuergerät kommt. In dem Motorsteuergerät sind die jeweiligen PWM-Raten für die einzelnen Glühstifte und Ansteuerungsphasen (Pushen, Glühen, Nachglühen) hinterlegt. Die einzelnen Glühstifte werden über Leistungstransistoren angesteuert, welche pulsweitenmoduliert gesteuert werden.

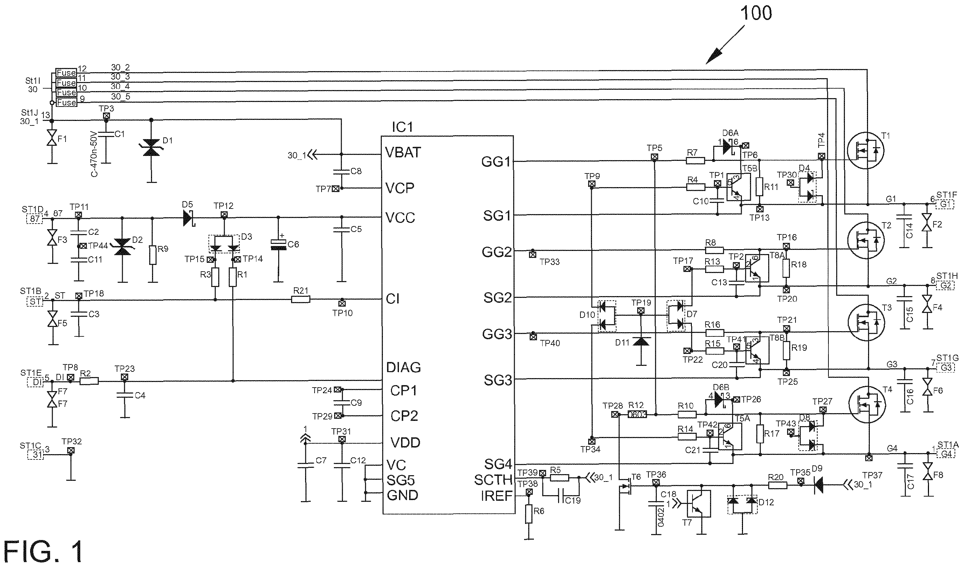

Fig. 1 zeigt einen Schaltplan eines Glühzeitsteuergeräts 100 für vier Glühstifte eines Fahrzeugs. Das Glühzeitsteuergerät 100 umfasst vier Leistungstransistoren T1-T4, welchen jeweils ein entsprechender Glühstiftsteuerausgang G1-G4 zugeordnet ist. An die Glühstiftsteuerausgänge G1-G4 können die vier Glühstifte angeschlossen werden. Im durchgeschalteten Zustand der Leistungstransistoren T1-T4 wird Strom vom Bordnetz des Fahrzeugs, welcher über einen Anschluss 30 dem Steuergerät 100 zugeführt wird, zu dem entsprechenden Glühstiftsteuerausgang G1-G4 geleitet. Eine Überwachung der von den Glühstiftsteuerausgängen G1-G4 ausgegebenen Spannung erfolgt über Eingänge SG1-SG4 eines integrierten Schaltkreises IC1. Der integrierte Schaltkreis IC1 weist darüber hinaus Steuerausgänge GG1-GG3 zum Ansteuern der Leistungstransistoren T1-T4 auf. Der integrierte Schaltkreis IC1 weist jedoch nur drei Steuerausgänge GG1-GG3 auf, so dass der Steuerausgang GG1 zum Ansteuern der Leistungstransistoren T1 und T4 verwendet wird. Die Steuerausgänge GG2 und GG3 steuern jeweils individuell die Leistungstransistoren T2 und T3 an. Der integrierte Schaltkreis IC1 umfasst zusätzlich eine Ladungspumpe, welche zum Bereitstellen der Steuersignale an den Steuerausgängen GG1-GG3 verwendet wird. Die Ladungspumpe erzeugt eine Spannung, welche größer als die üblichen 12 bis 14 V der Bordspannung des Fahrzeugs sind, um die Leistungstransistoren T1-T4 derart anzusteuern, dass ein Spannungsabfall über den Leistungstransistoren T1-T4 möglichst gering ist, um eine thermische Zerstörung der Leistungstransistoren T1-T4 zu vermeiden. Das Steuersignal an den Steuerausgängen GG1-GG3 kann beispielsweise 25 V betragen. Weiterhin erzeugt der integrierte Schaltkreis IC1 eine Versorgungsspannung VDD von näherungsweise 4 V, wenn der integrierte Schaltkreis IC1 aktiv ist, d.h. wenn der integrierte Schaltkreis IC 1 mit Masse und Versorgungsspannung versorgt wird.

Bei der Montage des Fahrzeugs oder bei Reparaturen an dem Fahrzeug kann es vorkommen, dass versehentlich 12 V oder Masse an die Glühstiftsteuerausgänge G1-G4 angelegt werden. Dies kann zur Zerstörung der Leistungstransistoren T1-T4 oder weiterer Komponenten des Glühzeitsteuergeräts führen. Darüber hinaus kann bei der Montage des Fahrzeugs oder bei einer Reparatur eine Verpolung oder ein sonstiges fehlerhaftes Anschließen des Glühzeitsteuergeräts 100 vorkommen, so dass schädliche Spannungen an den Anschlüssen des Glühzeitsteuergeräts anliegen. Weiterhin kann es beispielsweise beim Handhaben des Glühzeitsteuergeräts vorkommen, dass hohe Spannungen von beispielsweise einigen hundert oder tausend Volt aufgrund von elektrostatischen Entladungen an den Anschlüssen des Glühzeitsteuergeräts auftreten. Daher weist das Glühzeitsteuergerät der Fig. 1 Schutzschaltungen auf, welche nachfolgend im Detail beschrieben werden, um eine Zerstörung des Glühzeitsteuergeräts zu vermeiden und somit einen zuverlässigen Betrieb des Fahrzeugs, in dem das Glühzeitsteuergerät eingebaut ist, sicherzustellen.

Ein erster Schutzschaltkreis besteht aus der Diode D9, dem Widerstand R20, der Diode D12, dem Transistor T7, dem Kondensator C18, dem Transistor T6 und dem Widerstand R12. Bei einem Kurzschluss nach +12 V an dem Glühstiftsteuerausgang G1 kann das Gate von T4 angesteuert werden, wenn im integrierten Schaltkreis IC1 ein großer Widerstand zwischen dem Steuerausgang GG1 und Masse besteht. Der Widerstand im integrierten Schaltkreis IC1 kann beispielsweise mehrere hundert Kiloohm betragen, insbesondere wenn keine Versorgungsspannung VCC über den Anschluss 87 des Glühzeitsteuergeräts bereitgestellt wird. Darüber hinaus kann, wenn der Anschluss SG1 an dem integrierten Schaltkreis IC1 sehr stark nach oben gezogen wird, auch der Steuerausgang GG1 leicht angehoben werden. Somit kann der Leistungstransistor T4 unbeabsichtigt durchgeschaltet werden, wodurch der Leistungstransistor T4 oder ein daran angeschlossener Glühstift beschädigt werden können. Wenn die Versorgungsspannung VCC über den Anschluss 87 nicht vorhanden ist, stellt der integrierte Schaltkreis IC1 am Ausgang VDD keine Spannung bereit. Da der Ausgang VDD mit der Basis des Transistors T7 gekoppelt ist, sperrt der Transistor T7 in diesem Fall. Solange Batteriespannung über die Anschlüsse 30 bzw. 30_1 vorhanden ist, wird der Transistor T6 über die Diode D9 und den Widerstand R20 angesteuert und zieht die Gates der Leistungstransistoren T1 und T4 über den Widerstand R12 auf Masse, wodurch die Leistungstransistoren T1 und T4 sperren. Dadurch kann ein unbeabsichtigtes Einschalten des Transistors T4 vermieden werden, wenn beispielsweise +12 V an dem Glühstiftsteuerausgang G1 angelegt werden. Umgekehrt wird durch die Schutzschaltung des Transistors T6 ein Durchschalten des Leistungstransistors T1 verhindert, wenn an dem Glühstiftsteuerausgang G4 ein unbeabsichtigtes Potenzial von +12 V angelegt wird. Die Diode D9, der Widerstand R20 und die Diode D12 sind Schutzmaßnahmen für den Transistor T6. Wenn der integrierte Schaltkreis IC1 über den Anschluss 87 die Versorgungsspannung VCC erhält, gibt der integrierte Schaltkreis IC1 über den Anschluss VDD eine Spannung von beispielsweise 4 V an die Basis des Transistors T7 aus, wodurch dieser leitet und den Transistor T6 sperrt. Somit ist die Schutzschaltung des Transistors T6 bei aktivem Schaltkreis IC1 deaktiviert, da in diesem Fall der integrierte Schaltkreis IC1 das Potenzial auf dem Steuerausgang GG1 kontrolliert und somit einen Schutz für die Leistungstransistoren T1 und T4 bereitstellt. Außerdem wird durch das Sperren des Transistors T6 vermieden, dass die Ansteuerung der Leistungstransistoren T1 und T4 von dem Steuerausgang GG1 durch die Schutzschaltung rund um den Transistor T6 beeinflusst wird. Der Transistor T6 kann als Feldeffekttransistor (FET) ausgebildet sein, wodurch ein geforderter Ruhestrom in einem Schlafmodus des Glühzeitsteuergeräts 100 eingehalten werden kann.

Eine weitere Schutzschaltung bilden die Widerstände R11, R18, R19 und R17, welche den Leistungstransistoren T1-T4 zugeordnet sind. Mit Hilfe der Widerstände R11, R17, R18 und R19 werden die Gates der Leistungstransistoren T1-T4 auf das Potenzial der Source-Anschlüsse der Leistungstransistoren T1-T4 vorgespannt, um bei fehlendem Steuersignal am hochohmigen Gate-Eingang des Leistungstransistors T1-T4 diesen nach unten zu ziehen, um den Leistungstransistor T1-T4 auszuschalten. Das Steuersignal am Gate des Leistungstransistors T1-T4 kann fehlen, wenn beispielsweise der integrierte Schaltkreis IC1 ausfällt, einer der Anschlusspins GG1-GG3 abreißt oder eine Verbindungsunterbrechung zwischen dem integrierten Schaltkreis IC1 und den Leistungstransistoren T1-T4 auftritt.

Einen weiteren Schutzmechanismus bilden die Diodenpaare D4 und D8. Durch die Parallelschaltung der Gates der Leistungstransistoren T1 und T4 an dem gemeinsamen Steuerausgang GG1 kann durch einen Kurzschluss von beispielsweise dem Glühstiftsteuerausgang G1 nach Masse eine hohe Spannungsdifferenz zwischen dem Gate und dem Source des Leistungstransistors T1 anliegen, beispielsweise eine Spannung von ungefähr 25 V. Im Normalfall, d.h. ohne den Kurzschluss von G1 nach Masse, passiert dies nicht, da hier das Gate langsame hoch und runter geführt wird und der Source-Anschluss des Leistungstransistors T1 dann nachfolgt. Um diese Spannungsdifferenz zu vermeiden und eine Beeinflussung des Leistungstransistors T4 durch diese Spannungsdifferenz zu vermeiden, wird die Spannung zwischen Gate und Source am Leistungstransistor T1 durch das Diodenpaar D4 begrenzt, beispielsweise auf 18 V. Das Diodenpaar D4 besteht aus zwei in Serie geschaltete und entgegengesetzt gerichtete Zener-Dioden. Das Diodenpaar D8 stellt einen vergleichbaren Schutz am Leistungstransistor T4 bereit.

Die Transistoren T5A, T5B, T8A und T8B dienen zum Schutz bei Masseversatz bzw. Masseverlust. Sie schalten die Leistungstransistoren T1-T4 aktiv aus, bevor das Massepotenzial über die Schwellenspannung in Bezug zum Glühstiftmassepotenzial ansteigt. Die Dioden D7, D10 und D11 entkoppeln die Basisströme, sorgen für den Stromfluss in die richtige Richtung und legen die Schwellenspannung fest. Die Kondensatoren C10, C13, C20 und C21 entprellen diesen Effekt und verzögern das Zuschalten um beispielsweise 50 bis 100 µs. Aufgrund der gemeinsamen Ansteuerung der Leistungstransistoren T1 und T4 von dem Steuerausgang GG1 werden zusätzlich die Dioden D6A und D6B eingesetzt, um eine gegenseitige Beeinflussung der Leistungstransistoren T1 und T4 zu vermeiden, wie nachfolgend gezeigt werden wird. Bei einem Schluss von G1 nach Plus hat das Gate von Leistungstransistor T4 ein zu hohes Potenzial, wie zuvor in Verbindung mit der Schutzschaltung um den Transistor T6 beschrieben wurde. Durch das angehobene Potenzial am Steuerausgang G1 bricht die Emitter-Basisstrecke von T5B bei einer Spannung von mehr als 5 V durch. Dadurch wirkt der PN-Übergang von Basis nach Kollektor in dem Transistor T5B. Ohne die Diode D6A würde das Gate von dem Leistungstransistor T4 nun um ca. 6 V unterhalb der Spannung an dem Anschluss SG1 hochgezogen werden, wodurch der Leistungstransistor T4 durchschalten würde. Die Diode D6A sperrt in diesem Fall den Stromfluss, lässt aber das Sperren bei Masseversatz zu. Die Diode D6A ist vorzugsweise eine Schottky-Diode, um die Vorwärtsspannung niedrig zu halten und unter allen Bedingungen unterhalb der FET-Schwellenspannung von typischerweise 2 V zu bleiben. Die Diode D6B stellt einen vergleichbaren Schutz für den Leistungstransistor T1 bei einem Schluss von G4 nach Plus bereit.

Als einen weiteren Schutz für das Glühzeitsteuergerät 100 sind an den externen Anschlüssen 30_1, 87, ST, DI, G1, G2, G3 und G4 acht ESD-Funkenstrecken F1-F8 gegen sehr hohe Überspannungen und Entladungen vorgesehen, welche die Energie von derartigen Überspannungen und Entladungen nach Masse ableiten. Derartige elektrostatische Entladungen können mehrere hundert bis mehrere tausend Volt betragen. Die ESD-Funkenstrecken F1-F8 befinden sich direkt neben den Steckeranschlüssen auf der Leiterplatte und lassen definiert einen elektrischen Funken überspringen, bevor dieser weiter ins Gerät vordringen kann. Die ESD-Funkenstrecken (engl. Electrostatic Discharge, ESD) sind Leiterplattenstrukturen, d.h. der elektrische Funke springt in der Luft zwischen zwei Leiterbahnen über. Dadurch lassen sich auch hochohmige Eingänge schützen.

Schließlich sind in dem Glühzeitsteuergerät 100 vier Sicherungen (engl.: Fuse) 9-12 vorgesehen, welche in den Versorgungsspannungsleitungen zu den Drain-Anschlüssen der Leistungstransistoren T1-T4 liegen. Somit sind die einzelnen Pfade für die Glühstifte G1-G4 separat abgesichert. Dadurch können die einzelnen Pfade gezielt angesteuert und entsprechend deaktiviert werden.

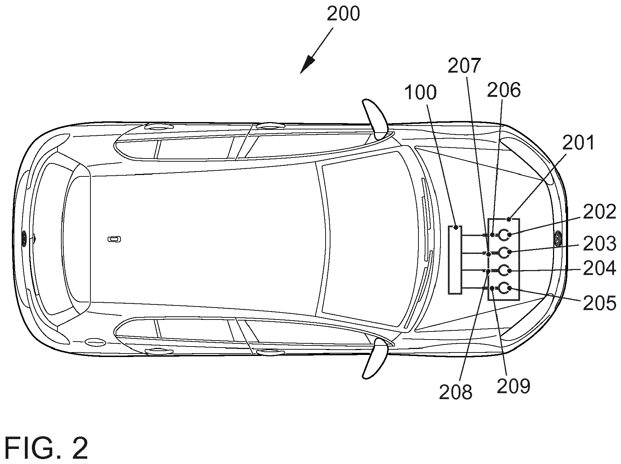

Fig. 2 zeigt ein Fahrzeug 200 mit einem Motor 201 mit vier Zylindern 202-205. Jedem Zylinder 202-205 ist jeweils ein Glühstift 206-209 zugeordnet. Die Glühstifte 206-209 werden von einem Glühzeitsteuergerät 100 angesteuert.

## Patentansprüche

1. Glühzeitsteuergerät zum Ansteuern von Glühstiften in einem Fahrzeug, umfassend:
- eine Steuereinheit (IC1) mit einem Steuerausgang (GG1) zum Ausgeben eines Steuersignals und einem Versorgungsspannungseingang (VCC),
- mindestens zwei Leistungstransistoren (T1, T4), welchen jeweils ein entsprechender Glühstiftsteuerausgang (G1, G4) zugeordnet ist und deren Steuereingänge mit einem Steuerausgang (GG1) der Steuereinheit (IC1) gekoppelt sind, und
- einen Schutzschaltkreis (T6, T7) mit einem Schutzschaltkreisausgang, welcher mit den Steuereingängen der mindestens zwei Leistungstransistoren (T1, T4) gekoppelt ist,
**dadurch gekennzeichnet, dass**
die Steuereinheit einen Versorgungsspannungsausgang (VDD) aufweist, wobei die Steuereinheit (IC1) eingerichtet ist, in Abhängigkeit von einer Spannung an dem Versorgungsspannungseingang (VCC) eine Ausgangsspannung an dem Versorgungsspannungsausgang (VDD) bereitzustellen, und der Schutzschaltkreis (T6, T7) einen Eingang aufweist, welcher mit dem Versorgungsspannungsausgang (VDD) der Steuereinheit (IC1) gekoppelt ist, wobei der Schutzschaltkreis (T6, T7) eingerichtet ist, an dem Schutzschaltkreisausgang ein vorgegebenes Potenzial einzustellen, wenn die Ausgangsspannung der Steuereinheit (IC1) unterhalb eines vorgegeben Werts ist.

2. Glühzeitsteuergerät nach Anspruch 1, wobei das vorgegebene Potenzial ein Potenzial ist, welches die mindestens zwei Leistungstransistoren (T1, T4) sperrt.

3. Glühzeitsteuergerät nach einem der Ansprüche 1 oder 2 , wobei
mindestens zwei Transistoren (T5A, T5B) jeweils einem der mindestens zwei Leistungstransistoren (T1, T4) zugeordnet sind, wobei eine Schaltstrecke des einem Leistungstransistor (T1, T4) zugeordneten Transistors (T5A, T5B) zwischen den Steuereingang und einem Ausgang des zugeordneten Leistungstransistors (T1, T4) geschaltet ist, wobei zwischen den Transistor (T5A, T5B) und dem Steuereingang des Leistungstransistors (T1, T4) eine Diode (D6A, D6B) geschaltet ist.

4. Glühzeitsteuergerät nach Anspruch 3, wobei der Leistungstransistor (T1, T4) einen Feldeffekttransistor mit einem Gate-Anschluss als den Steuereingang und einem Source-Anschluss umfasst,
wobei ein Emitter des Transistors (T5A, T5B) mit dem Source-Anschluss gekoppelt ist, ein Kollektor-Anschluss des Transistors (T5A, T5B) über die Diode (D6A, D6B) mit dem Gate-Anschluss gekoppelt ist und eine Basis des Transistors (T5A, T5B) über einen Kondensator (C10, C21) mit dem Source-Anschluss und über eine weitere Diode (D10) mit einem Masseanschluss des Glühzeitsteuergeräts (100) gekoppelt ist.

5. Glühzeitsteuergerät nach Anspruch 3 oder 4, wobei die Diode (D6A, D6B) eine Schottky-Diode umfasst.

6. Glühzeitsteuergerät nach einem der vorstehenden Ansprüche, wobei
mindestens zwei Zener-Dioden-Paare (D4, D8) jeweils einem der mindestens zwei Leistungstransistoren (T1, T4) zugeordnet sind, wobei das einem Leistungstransistor (T1, T4) zugeordnete Zener-Dioden-Paar (D4, D8) zwischen den Steuereingang und einem Ausgang des Leistungstransistors (T1, T4) geschaltet ist, wobei das Zener-Dioden-Paar (D4, D8) eine Reihenschaltung von zwei Zener-Dioden umfasst, welche in entgegengesetzte Richtungen geschaltet sind.

7. Glühzeitsteuergerät nach einem der vorstehenden Ansprüche, umfassend:
- eine Leiterplatte,
- einen Masseanschluss (31), welcher mit einer ersten Leiterbahn der Leiterplatte gekoppelt ist,
- mindestens einen elektrischen Anschluss (30_1, 87, ST, DI; G1-G4) auf der Leiterplatte, welcher mit einer zweiten Leiterbahn der Leiterplatte gekoppelt ist und zum elektrischen Verbinden der zweiten Leiterbahn mit einer zu dem Glühzeitsteuergerät externen Vorrichtung ausgestaltet ist, und
- eine ESD-Funkenstrecke (F1-F8), welche benachbart zu dem elektrischen Anschluss zwischen der ersten Leiterbahn und der zweiten Leiterbahn ausgebildet ist.

8. Glühzeitsteuergerät nach Anspruch 7, wobei die ESD-Funkenstrecke (F1-F8) eine Luftstrecke zwischen der ersten Leiterbahn und der zweiten Leiterbahn mit einer vorgegebenen Länge umfasst.

9. Glühzeitsteuergerät nach einem der vorstehenden Ansprüche, umfassend:
- mindestens zwei Leistungstransistoren (T1-T4), welchen jeweils ein entsprechender Glühstiftsteuerausgang (G1-G4) zugeordnet ist, und
- mindestens zwei Sicherungen (9-12), welche jeweils einem der mindestens zwei Leistungstransistoren (T1-T4) zugeordnet sind.

10. Glühzeitsteuergerät nach Anspruch 9, wobei die Sicherung (9-12) eine Schmelzsicherung umfasst.

11. Fahrzeug, umfassend:
- mindestens einen Glühstift (206-209), und
- ein Glühzeitsteuergerät (100) nach einem der vorhergehenden Ansprüche, welches mit dem mindestens einen Glühstift (206-209) gekoppelt ist.

## Claims

1. Glow time control device for actuating glow plugs in a vehicle, comprising:
- a control unit (IC1) having a control output (GG1) for emitting a control signal and having a supply voltage input (VCC),
- at least two power transistors (T1, T4), which are respectively assigned a corresponding glow plug control output (G1, G4) and the control inputs of which are coupled to a control output (GG1) of the control unit (IC1), and
- a protection circuit (T6, T7) having a protection circuit output, which is coupled to the control inputs of the at least two power transistors (T1, T4),
**characterized in that**
the control unit has a supply voltage output (VDD), wherein the control unit (IC1) is configured to provide an output voltage at the supply voltage output (VDD) depending on a voltage at the supply voltage input (VCC), and the protection circuit (T6, T7) has an input, which is coupled to the supply voltage output (VDD) of the control unit (IC1), wherein the protection circuit (T6, T7) is configured to set a prescribed potential at the protection circuit output when the output voltage of the control unit (IC1) is below a prescribed value.

2. Glow time control device according to Claim 1, wherein the prescribed potential is a potential that turns the at least two power transistors (T1, T4) off.

3. Glow time control device according to either of Claims 1 and 2, wherein at least two transistors (T5A, T5B) are respectively assigned to one of the at least two power transistors (T1, T4), wherein a switching path of the transistor (T5A, T5B) assigned to a power transistor (T1, T4) is connected between the control input and an output of the assigned power transistor (T1, T4), wherein a diode (D6A, D6B) is connected between the transistor (T5A, T5B) and the control input of the power transistor (T1, T4).

4. Glow time control device according to Claim 3, wherein the power transistor (T1, T4) comprises a field-effect transistor having a gate terminal as the control input and having a source terminal, wherein an emitter of the transistor (T5A, T5B) is coupled to the source terminal, a collector terminal of the transistor (T5A, T5B) is coupled to the gate terminal via the diode (D6A, D6B) and a base of the transistor (T5A, T5B) is coupled to the source terminal via a capacitor (C10, C21) and to an earth terminal of the glow time control device (100) via a further diode (D10).

5. Glow time control device according to Claim 3 or 4, wherein the diode (D6A, D6B) comprises a Schottky diode.

6. Glow time control device according to one of the preceding claims, wherein at least two Zener diode pairs (D4, D8) are respectively assigned to one of the at least two power transistors (T1, T4), wherein the Zener diode pair (D4, D8) assigned to a power transistor (T1, T4) is connected between the control input and an output of the power transistor (T1, T4), wherein the Zener diode pair (D4, D8) comprises a series circuit of two Zener diodes connected in opposite directions.

7. Glow time control device according to one of the preceding claims, comprising:
- a printed circuit board,
- an earth terminal (31), which is coupled to a first conductor track of the printed circuit board,
- at least one electrical terminal (30_1, 87, ST, DI; G1-G4) on the printed circuit board, said electrical terminal being coupled to a second conductor track of the printed circuit board and being designed for electrically connecting the second conductor track to an apparatus outside of the glow time control device, and
- an ESD spark gap (F1-F8), which is formed adjacent to the electrical terminal between the first conductor track and the second conductor track.

8. Glow time control device according to Claim 7, wherein the ESD spark gap (F1-F8) comprises an air gap between the first conductor track and the second conductor track, said air gap having a prescribed length.

9. Glow time control device according to one of the preceding claims, comprising:
- at least two power transistors (T1-T4), which are respectively assigned a corresponding glow plug control output (G1-G4), and
- at least two fuses (9-12), which are respectively assigned to one of the at least two power transistors (T1-T4).

10. Glow time control device according to Claim 9, wherein the fuse (9-12) comprises a safety fuse.

11. Vehicle, comprising:
- at least one glow plug (206-209), and
- a glow time control device (100) according to one of the preceding claims, which is coupled to the at least one glow plug (206-209).

## Revendications

1. Appareil de commande de temps de préchauffage destiné à commander des bougies de préchauffage dans un véhicule, comprenant :
- une unité de commande (IC1) ayant une sortie de commande (GG1) destinée à délivrer un signal de commande et une entrée de tension d'alimentation (VCC),
- au moins deux transistors de puissance (T1, T4), auxquels est respectivement associée une sortie de commande de bougie de préchauffage (G1, G4) et dont les entrées de commande sont couplées à une sortie de commande (GG1) de l'unité de commande (IC1), et
- un circuit de protection (T6, T7) ayant une sortie de circuit de protection qui est couplée aux entrées de commande desdits au moins deux transistors de puissance (T1, T4),
**caractérisé en ce que**
l'unité de commande comporte une sortie tension d'alimentation (VDD), dans laquelle l'unité de commande (IC1) est conçue pour fournir une tension de sortie à la sortie de tension d'alimentation (VDD) en fonction d'une tension à l'entrée de tension d'alimentation (VCC), et le circuit de protection (T6, T7) comporte une entrée qui est couplée à la sortie de tension d'alimentation (VDD) de l'unité de commande (IC1), dans lequel le circuit de protection (T6, T7) est conçu pour régler un potentiel prédéterminé à la sortie du circuit de protection lorsque la tension de sortie de l'unité de commande (IC1) est inférieure à une valeur prédéterminée.

2. Appareil de commande de temps de préchauffage selon la revendication 1, dans lequel le potentiel prédéterminé est un potentiel qui bloque lesdits au moins deux transistors de puissance (T1, T4).

3. Appareil de commande de temps de préchauffage selon l'une des revendications 1 ou 2, dans lequel au moins deux transistors (T5A, T5B) sont respectivement associés à l'un desdits au moins deux transistors de puissance (T1, T4), dans lequel un trajet de commutation du transistor (T5A, T5B) associé à un transistor de puissance (T1, T4) est connecté entre l'entrée de commande et une sortie du transistor de puissance (T1, T4) associé, dans lequel une diode (D6A, D6B) est connectée entre le transistor (T5A, T5B) et l'entrée de commande du transistor de puissance (T1, T4).

4. Appareil de commande de temps de préchauffage selon la revendication 3, dans lequel le transistor de puissance (T1, T4) comprend un transistor à effet de champ ayant une borne de grille en tant qu'entrée de commande et une borne de source,
dans lequel un émetteur du transistor (T5A, T5B) est couplé à la borne de source, une borne de collecteur du transistor (T5A, T5B) est couplée à la borne de grille par l'intermédiaire de la diode (D6A, D6B), et une base du transistor (T5A, T5B) est couplée à la borne de source par l'intermédiaire d'un condensateur (C10, C21) et à une borne de masse de l'appareil de commande de temps de préchauffage (100) par l'intermédiaire d'une diode (D10).

5. Appareil de commande de temps de préchauffage selon la revendication 3 ou 4, dans lequel la diode (D6A, D6B) comprend une diode Schottky.

6. Appareil de commande de préchauffage selon l'une des revendications précédentes, dans lequel
au moins deux paires de diodes Zener (D4, D8) sont respectivement associées à l'un desdits au moins deux transistors de puissance (T1, T4), dans lequel la paire de diodes Zener (D4, D8) associée à un transistor de puissance (T1, T4) est connectée entre l'entrée de commande et une sortie du transistor de puissance (T1, T4), dans lequel la paire de diodes Zener (D4, D8) comprend une connexion en série de deux diodes Zener qui sont connectées dans des sens opposés.

7. Appareil de commande de temps de préchauffage selon l'une des revendications précédentes, comprenant :
- une carte de circuit imprimé,
- une borne de masse (31) qui est couplée à une première piste conductrice de la carte de circuit imprimé,
- au moins une connexion électrique (30_1, 87, ST, DI ; G1-G4) sur la carte de circuit imprimé, qui est couplée à une deuxième piste conductrice de la carte de circuit imprimé et qui est configurée pour relier électriquement la deuxième piste conductrice à un dispositif extérieur à l'unité de commande du temps de préchauffage, et
- un éclateur ESD (F1-F8) qui est adjacent à la connexion électrique entre la première piste conductrice et la deuxième piste conductrice.

8. Appareil de commande de temps de préchauffage selon la revendication 7,
dans lequel l'éclateur ESD (F1-F8) comprend un intervalle d'air de longueur prédéterminée entre la première piste conductrice et la deuxième piste conductrice.

9. Appareil de commande de temps de préchauffage selon l'une des revendications précédentes, comprenant :
- au moins deux transistors de puissance (T1-T4) qui sont respectivement associés à une sortie de commande de bougie de préchauffage (G1-G4) correspondante, et
- au moins deux dispositifs de protection (9-12) qui sont respectivement associés à l'un desdits au moins deux transistors de puissance (T1-T4).

10. Appareil de commande de temps de préchauffage selon la revendication 9, dans lequel le dispositif de protection (9-12) comprend un fusible.

11. Véhicule, comprenant :
- au moins une bougie de préchauffage (206-209), et
- un appareil de commande de temps de préchauffage (100) selon l'une des revendications précédentes, qui est couplé à ladite au moins une bougie de préchauffage (206-209).
